# EUROPÄISCHE PATENTSCHRIFT

(11) **EP 0 928 425 B1**
(45) Veröffentlichungstag und Bekanntmachung des Hinweises auf die Patenterteilung: **03.03.2004**
(21) Anmeldenummer: 97913088.7
(22) Anmeldetag: 24.09.1997
(51) Int. Cl.: G01R 31/327

(54) **PRÜFEINRICHTUNG FÜR EINE ELEKTRONISCHE AUSLÖSEEINRICHTUNG**
TEST DEVICE FOR AN ELECTRONIC TRIPPING DEVICE
DISPOSITIF D'ESSAI POUR DECLENCHEUR ELECTRONIQUE

(30) Priorität: 24.09.1996 DE 29617363 U
(43) Veröffentlichungstag der Anmeldung: 14.07.1999
(73) Patentinhaber: SIEMENS AKTIENGESELLSCHAFT, 80333 München (DE)
(72) Erfinder: BAUMGÄRTL, Ulrich, D-13599 Berlin (DE); RÖHL, Wolfgang, D-13503 Berlin (DE)
(86) Internationale Anmeldenummer: PCT/DE1997/002209
(87) Internationale Veröffentlichungsnummer: WO 1998/013702

(56) Entgegenhaltungen:
- DE-A- 1 588 924
- DE-B- 2 658 185
- ABRI A ET AL: "MECHANISM OF INTERACTION BETWEEN ELECTRIC ARC AND BREAKING CHAMBER IN LOW VOLTAGE CURRENT LIMITING CIRCUIT BREAKERS" CONFERENCE RECORD OF THE INDUSTRY APPLICATIONS SOCIETY ANNUAL MEETING. (IAS), SAN DIEGO, OCT. 1 - 5, 1989, Bd. PART 2, 1.Oktober 1989, INSTITUTE OF ELECTRICAL AND ELECTRONICS ENGINEERS, Seiten 1895-1903, XP000091768

## Beschreibung

Die Erfindung betrifft eine Prüfeinrichtung für eine elektronische Auslöseeinrichtung, insbesondere für Überstromauslöser der Nieder- und Mittelspannungstechnik, mit einem Netztransformator.
Derartige Prüfeinrichtungen sind bisher mit Netztransformatoren für relativ hohe Ausgangspannungen ausgestattet. Zwischen dem Netztransformator und der zu prüfenden elektronischen Auslöseeinrichtung ist eine entsprechend dimensionierte Impedanz geschaltet. Desweiteren ist es bekannt, eine von einem Netzteil erzeugte Gleichspannung mit einer Leistungs-Konstant-Stromquelle in einen konstanten Wechselstrom umzusetzen und damit die elektronischen Auslöseeinrichtungen zu prüfen. In beiden Fällen ist der Netztransformator für hohe Leistungen mit entsprechend großer Verlustleistung ausgelegt. Dies gilt gleichermaßen auch für die Konstant-Stromquelle.

Die der Erfindung zugrundeliegende Aufgabe besteht darin, eine Prüfeinrichtung zu definieren, deren Netztransformator erheblich weniger aufwendig und insbesondere mit erheblich geringerer Verlustleistung behaftet ist.

Erfindungsgemäß wird diese Aufgabe dadurch gelöst, daß die Stromsenke durch eine netzsynchronisierte Funktionsgeneratoreinrichtung gesteuert ist, wobei ein Steuereingang der Stromsenke mit der Funktionsgeneratoreinrichtung verbunden ist, so dass das Ausgangssignal der Stromsenke in Abhängigkeit vom Ausgangssignal der Funktionsgeneratoreinrichtung wechselstrommoduliert ist.

Mit dem Steuern der Stromsenke durch die netzsynchronisierte Funktionsgeneratoreinrichtung, wodurch das Ausgangssignal der Stromsenke wechselstrommoduliert ist, benötigt der Netztransformator nur eine relativ kleine Sekundärspannung, die im Bereich von 10 Volt liegt. Damit ergibt sich bereits eine wesentlich geringere Verlustleistung. Da außerdem der schon annähernd sinusförmige Ausgangsstrom des Netztransformators nachgeformt wird, ergibt sich auch in diesem Zusammenhang eine sehr viel geringere Verlustleistung. Der Netztransformator insgesamt ist für eine geringere Verlustleistung ausgelegt. Darüber hinaus sind mit dem erfindungsgemäßen Einsatz der Stromsenke in vorteilhafter Weise die Schwankungen der Netzspannung im Bereich von (+/-) 10 % ausgeregelt.

Durch die DE 26 58 185 ist eine Schaltungsanordnung zum Prüfen von Fehlerspannungs- bzw. Fehlerstromschutzschaltern bekannt geworden, die einen Netztransformator und eine Stromsenke aufweist. Im Unterschied zur Erfindung stellt die Stromsenke dieser Schaltungsanordnung einen in feinen Stufen allmählich ansteigenden Prüfstrom bereit. Auch sind die hier benötigten Ströme klein und daher im Unterschied zu den Prüfströmen eines Überstromauslösers problemlos zu erzeugen.

Gemäß einer vorteilhaften Ausgestaltung der Erfindung ist vorgesehen, daß die Funktionsgeneratoreinrichtung durch einen Hilfstransformator gebildet ist, so daß für Anwendungen, in denen vorhandene Netzspannungsschwankungen nicht ausgeregelt werden müssen, statt der teueren Funktionsgeneratoreinrichtung der vergleichsweise preiswertere Hilfstransformator eingesetzt werden kann.

Die Erfindung wird durch ein Ausführungsbeispiel näher erläutert, in dem lediglich die zum Verständnis der Erfindung wesentlichen Schaltelemente auszugsweise dargestellt sind.

Die Prüfeinrichtung (PE) enthält neben dem Netztransformator (NT) die Stromsenke (KS), die durch die Funktionsgeneratoreinrichtung (FG) derart gesteuert ist, daß das Ausgangssignal der Stromsenke (KS) wechselstrommoduliert der elektronischen Auslöseeinrichtung (AE) zur Verfügung steht. Da die Funktionsgeneratoreinrichtung (FG) über den Steuereingang Tr durch die Netzspannung getriggert ist, ist auch das wechselstrommodulierte Ausgangssignal der Stromsenke (KS) mit der Frequenz und der Phase der Netzspannung moduliert.
Für Prüfvorgänge, bei denen Schwankungen der Netzspannung nicht ausgeregelt werden müssen, kann anstatt der Funktionsgeneratoreinrichtung (FG) ein Hilfstransformator zur Ansteuerung der Stromsenke (KS) eingesetzt werden.

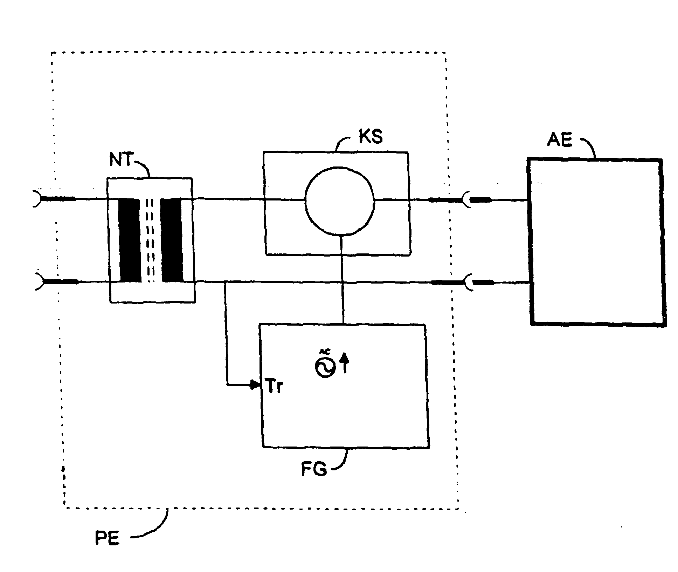

## Patentansprüche

1. Prüfeinrichtung für eine elektronische Auslöseeinrichtung, insbesondere für Überstromauslöser der Nieder- und Mittelspannungstechnik, mit einem Netztransformator und mit einer Stromsenke,
**dadurch gekennzeichnet, dass**
die Stromsenke (KS) durch eine netzsynchronisierte Funktionsgeneratoreinrichtung (FG) gesteuert ist, wobei ein Steuereingang der Stromsenke mit der Funktionsgeneratoreinrichtung verbunden ist, so dass das Ausgangssignal der Stromsenke in Abhängigkeit vom Ausgangssignal der Funktionsgeneratoreinrichtung wechselstrommoduliert ist.

2. Prüfeinrichtung für eine elektronische Auslöseeinrichtung nach Anspruch 1,
**dadurch gekennzeichnet, dass**
die Funktionsgeneratoreinrichtung (FG) durch einen Hilfstransformator gebildet ist.

## Claims

1. Test device for an electronic tripping device, in particular for an overcurrent release for low-voltage and medium-voltage technology, having a mains transformer and having a current sink,
**characterized in that**
the current sink (KS) is controlled by a mains-synchronized function generator device (FG), with a control input for the current sink being connected to the function generator device such that the output signal from the current sink is alternating-current-modulated as a function of the output signal from the function generator device.

2. Test device for an electronic tripping device according to Claim 1,
**characterized in that**
the function generator device (FG) is formed by an auxiliary transformer.

## Revendications

1. Dispositif de test pour un déclencheur électronique, notamment pour un déclencheur à surintensité de courant en basse et moyenne tension, comportant un transformateur de distribution et une source de courant,
**caractérisé par le fait que** la source de courant (KS) est commandée par un dispositif générateur de fonction (FG) synchronisé sur le réseau, une entrée de commande de la source de courant étant reliée au dispositif générateur de fonction de telle sorte que le signal de sortie de la source de courant est modulé en courant alternatif en fonction du signal de sortie du dispositif générateur de fonction.

2. Dispositif de test pour un déclencheur électronique selon la revendication 1,
**caractérisé par le fait que** le dispositif générateur de fonction (FG) est formé par un transformateur auxiliaire.
